# EUROPEAN PATENT APPLICATION

(11) **EP 4 756 435 A1**
(43) Date of publication of application: **10.06.2026**
(21) Application number: 25218949.3
(22) Date of filing: 27.11.2025
(51) Int. Cl.: G01R 15/18, G01R 19/00, H01T 1/12, H02H 7/24, H02H 3/04, H02H 9/04, H02H 3/08

(54) **SIGNAL DETECTION APPARATUS FOR SURGE PROTECTOR AND SURGE PROTECTOR**

(30) Priority: 28.11.2024 CN 202422922923 U
(71) Applicant: SCHNEIDER ELECTRIC INDUSTRIES SAS, 92500 Rueil-Malmaison (FR)
(72) Inventor: YU, Gang, 201203 Shanghai (CN); TIAN, Simon, 201203 Shanghai (CN); HUANG, Xuechun, 201203 Shanghai (CN); LI, Xiaodong, 201203 Shanghai (CN)
(74) Representative: Openshaw & Co.

(57) **Abstract**

A signal detection apparatus (1) includes an acquisition assembly, a charging capacitor (3), an AC-DC conversion module (4), a detection capacitor (5), and a pair of voltage detection interfaces (6). The acquisition assembly is coupled to a target line (11) to acquire a surge signal in the target line (11). The acquisition assembly includes at least two acquisition coils (2) connected in series. Two ends of the charging capacitor (3) are respectively coupled to the acquisition assembly, and the charging capacitor (3) is adapted to be charged by the acquisition assembly. The AC-DC conversion module (4) is connected in parallel to the charging capacitor (3) to convert an AC voltage output by the charging capacitor (3) into a DC voltage. The detection capacitor (5) is coupled to the AC-DC conversion module (4) to be charged by the AC-DC conversion module (4). The pair of voltage detection interfaces (6) are respectively coupled to two ends of the detection capacitor (5) to detect a voltage across the detection capacitor (5).

## Description

### FIELD

Example embodiments of the present disclosure relate generally to electrical devices, and more particularly to a signal detection apparatus for a surge protector and a surge protector.

### BACKGROUND

A surge protector is an electrical device in an electrical system that protects a device from transient overvoltage (surge) caused by factors such as lightning, grid operating overvoltage, and electrostatic discharge.

When a surge voltage occurs, the surge protector can detect the surge voltage and act (such as being broken down) in an extremely short time. In this way, the voltage across the electrical device connected within its protection range can be limited, and the voltage borne by the device is ensured to be within a safe range. Therefore, the electrical device can operate normally and stably.

### SUMMARY

In a first aspect of the present disclosure, a signal detection apparatus for a surge protector is provided. The signal detection apparatus includes an acquisition assembly, a charging capacitor, an AC-DC conversion module, a detection capacitor, and a pair of voltage detection interfaces. The acquisition assembly is coupled to a target line and adapted to acquire a surge signal in the target line. The acquisition assembly includes at least two acquisition coils connected in series in sequence and arranged in a radial direction of the target line that is perpendicular to an axis of the target line, and at least partially of which extending along a circumferential direction of the target line. Two ends of the charging capacitor are respectively coupled to the acquisition assembly, and the charging capacitor is adapted to be charged by the acquisition assembly during current fluctuation of the target line. The AC-DC conversion module is connected in parallel to the charging capacitor and adapted to convert an AC voltage output by the charging capacitor into a DC voltage. The detection capacitor is coupled to the AC-DC conversion module and adapted to be charged by the AC-DC conversion module. The pair of voltage detection interfaces are respectively coupled to two ends of the detection capacitor and adapted to detect a voltage across the detection capacitor.

In some embodiments, the at least two acquisition coils include two acquisition coils arranged on two opposite sides of the target line, and winding directions of the two acquisition coils are opposite.

In some embodiments, each of the at least two acquisition coils is a Rogowski coil.

In some embodiments, the signal detection apparatus further includes a semiconductor switch coupled to two ends of the detection capacitor.

In some embodiments, the semiconductor switch includes a MOSFET, and a source and a drain of the MOSFET are respectively coupled to two ends of the detection capacitor.

In some embodiments, the signal detection apparatus further includes: a current-limiting resistor arranged between the acquisition assembly and the charging capacitor and coupled in series to the charging capacitor.

In some embodiments, the signal detection apparatus further includes a protective diode connected in parallel to two ends of the detection capacitor and adapted to be broken down upon the voltage across the detection capacitor being greater than a predetermined threshold.

In some embodiments, the protective diode is a Zener diode.

In some embodiments, the signal detection apparatus further includes an analog-to-digital converter (ADC) coupled to the pair of voltage detection interfaces and adapted to acquire a voltage signal acquired by the pair of voltage detection interfaces.

According to embodiments of the present disclosure, current variations in the target line are acquired through at least two acquisition coils of the acquisition assembly, and a voltage is generated when the current in the target line varies, so as to charge the charging capacitor. After the voltage across the charging capacitor is higher than a predetermined voltage drop of the AC-DC conversion module, the charging capacitor charges the detection capacitor via the AC-DC conversion module. Since the detection capacitor does not have a discharge circuit, the voltage of the detection capacitor can be maintained within a stable range after it is charged. Furthermore, the voltage across the detection capacitor can be obtained through the pair of voltage detection interfaces, and an early warning (or counting) operation can be performed according to the comparison between the voltage across the detection capacitor and an early warning (or counting) threshold. In this way, the signal detection apparatus can accurately acquire the surge signal in the target line, and can also improve the sensitivity of detection for 10/350 µs waveform.

In a second aspect of the present disclosure, a surge protector is provided. The surge protector includes the signal detection apparatus provided by the first aspect of the present disclosure.

It should be understood that the content described in this content section is not intended to limit the key features or important features of embodiments of the present disclosure, nor is it intended to limit the scope of the present disclosure. Other features of the present disclosure will become readily understood from the following description.

### BRIEF DESCRIPTION OF DRAWINGS

The above and other features, advantages, and aspects of various embodiments of the present disclosure will become more apparent from the following detailed description taken in conjunction with the accompanying drawings. In the drawings, the same or similar reference numbers refer to the same or similar elements, wherein:
FIG. 1 shows a simplified schematic diagram of a surge protector according to some embodiments of the present disclosure; and
FIG. 2 shows a simplified schematic circuit diagram of a surge protector according to some embodiments of the present disclosure.

### DETAILED DESCRIPTION

Embodiments of the present disclosure will be described in more detail below with reference to the accompanying drawings. Although certain embodiments of the present disclosure are shown in the accompanying drawings, it should be understood that the present disclosure may be implemented in various forms, and should not be construed as limited to the embodiments set forth herein, but rather, these embodiments are provided for a more thorough and complete understanding of the present disclosure. It should be understood that the drawings and embodiments of the present disclosure are only used for illustrative purposes, and are not intended to limit the protection scope of the present disclosure.

It should be noted that the title of any section/subsection provided herein is not limiting. Various embodiments are described throughout and any type of embodiments may be included in any section/subsection. Furthermore, embodiments described in any section/subsection may be combined in any manner with the same section/subsection and/or any other embodiment described in different sections/subsections.

In the description of embodiments of the present disclosure, the term "including" and the like should be understood as open-ended inclusion, that is, "including but not limited to". The term "based on" should be understood as "based at least in part on". The term "an embodiment" or "the embodiment" should be understood as "at least one embodiment". The term "some embodiments" should be understood as "at least some embodiments". Other explicit and implicit definitions may also be included below. The terms "first", "second", etc. may refer to different or identical objects. Other explicit and implicit definitions may also be included below.

Standard-defined lightning strikes mainly include two forms, namely a 8/20 µs waveform and a 10/350 µs waveform. The "8" in the 8/20 µs waveform represents that the duration from the start of the current to when it rises to peak value is 8 microseconds, and the "20" represents that the duration from the start of the current to when it drops to half of the peak value is 20 microseconds. The "10" in the 10/350µs waveform represents that the duration from the start of the current to when it rises to peak value is 10 microseconds, while the "350" represents that the duration from the start of the current to when it drops to half of the peak value is 350 microseconds.

In a signal detection apparatus of a conventional surge protector, current variations in the electrical line are induced by a coil, and thus a voltage is generated to charge a capacitor. For the same current peak value, the voltage generated by the signal detection apparatus for the 8/20 µs waveform may be higher than that for the 10/350 µs waveform due to different change rates of the two waveforms. For example, for a surge signal with a current peak value of 1000A, the voltage generated by the signal detection apparatus for the 8/20 µs waveform is 0.8V, and the generated voltage for the 10/350 µs waveform is 0.4V. This results in a conventional signal detection apparatus requiring a current with a higher peak value for early warning (or counting) of the 10/350 µs waveform. That is, during use, the conventional surge protector may experience a delayed early warning (or delayed counting) for the 10/350µs waveform.

According to a signal detection apparatus for a surge protector and the surge protector provided by the present disclosure, the above problems and other potential problems existing in the conventional scheme are solved or at least partially solved. In the signal detection apparatus for the surge protector provided according to some embodiments of the present disclosure, current variations in a target line are acquired through at least two acquisition coils of an acquisition assembly, and a voltage is generated when the current in the target line varies, so as to charge a charging capacitor. After a voltage across the charging capacitor is higher than a predetermined voltage drop of an AC-DC conversion module, the charging capacitor charges a detection capacitor via the AC-DC conversion module. Since the detection capacitor does not have a discharge circuit, a voltage of the detection capacitor can be maintained within a stable range after it is charged. Furthermore, the voltage across the detection capacitor can be obtained through a pair of voltage detection interfaces, and an early warning (or counting) operation can be performed according to the comparison between the voltage across the detection capacitor and an early warning (or counting) threshold. In this way, the signal detection apparatus can accurately acquire the surge signal in the target line, and can also improve the sensitivity of detection for 10/350 µs waveform.

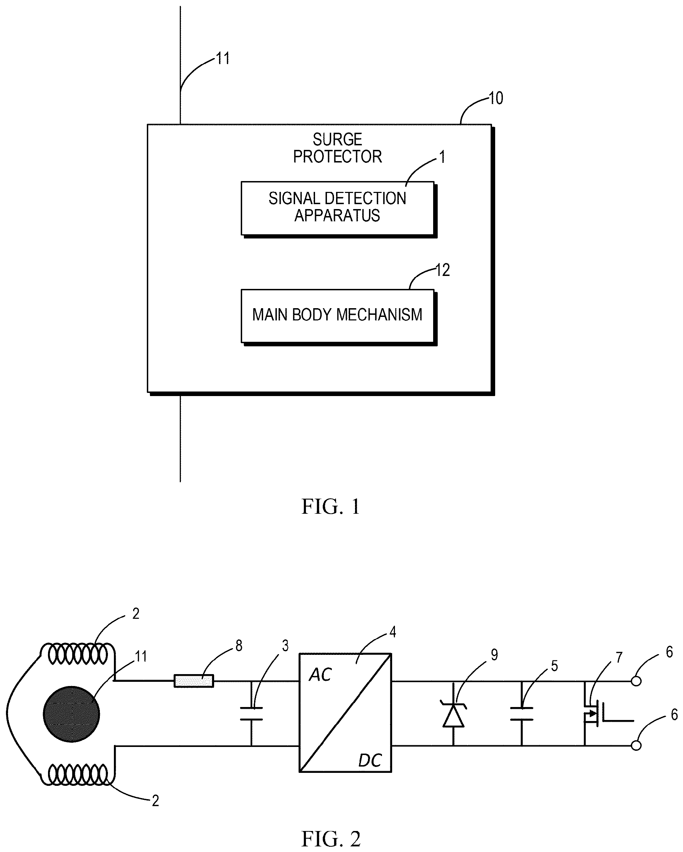

FIG. 1 shows a simplified schematic diagram of a surge protector according to some embodiments of the present disclosure. As shown in FIG. 1, the surge protector 10 generally includes a main body mechanism 12 and a signal detection apparatus 1 coupled to the main body mechanism 12. The signal detection apparatus 1 is coupled to a target line 11 and adapted to detect current variations of the target line 11, so as to send an early warning to the main body mechanism 12 when a surge occurs in the target line 11. In addition, the signal detection apparatus 1 may count a number of lightning strike occurrences on the surge protector 10, so that the user can check when needed.

FIG. 2 shows a simplified schematic circuit diagram of a surge protector according to some embodiments of the present disclosure. As shown in FIG. 2, the surge protector 10 includes an acquisition assembly, a charging capacitor 3 coupled to the acquisition assembly, an AC-DC conversion module 4 connected in parallel to the charging capacitor 3, a detection capacitor 5 coupled to the AC-DC conversion module 4, and a pair of voltage detection interfaces 6.

The acquisition assembly includes at least two acquisition coils 2. The at least two acquisition coils 2 are respectively arranged in a radial direction of the target line 11 that is perpendicular to its axial direction, and each of the acquisition coils 2 is at least partially arranged along a circumferential direction of the target line 11, so that the acquisition coils 2 can generate an induced voltage based on the current variations of the target line 11. In some embodiments, each acquisition coil 2 may be at least partially curved along the circumferential direction of the target line 11 to coincide with the circumferential direction of the target line 11. In some other embodiments, each acquisition coil 2 may be arranged to extend along a tangential direction related to the circumferential direction of the target line 11. In some embodiments, each acquisition coil 2 may be a Rogowski coil.

The at least two acquisition coils 2 are connected in series in sequence, and winding directions of the at least two acquisition coils 2 are arranged to be continuous along the circumferential direction (e.g., clockwise direction) of the target line 11. That is, during the current variations of the target line 11, the direction of the induced current in the at least two acquisition coils 2 is the same (for example, at least two induced currents generated by the at least two acquisition coils are both in a clockwise direction along the circumferential direction of the target line 11). In this way, induced voltages generated by the at least two acquisition coils may be superimposed with each other, thereby improving the charging efficiency of the charging capacitor 3.

In some embodiments, the acquisition assembly includes two acquisition coils 2, the two acquisition coils 2 being respectively arranged on two opposite sides of the target line 11 in the radial direction, and the winding directions of the two acquisition coils 2 are opposite. In this way, during the current variations of the target line 11, the two acquisition coils 2 may simultaneously induce induced currents in the same direction.

Two ends of the charging capacitor 3 are respectively coupled to two ends of the acquisition assembly so as to be charged by the acquisition assembly when the acquisition assembly induces an induced current. In some embodiments, a current-limiting resistor 8 is further arranged between the charging capacitor 3 and the acquisition assembly, and the current-limiting resistor 8 is connected in series to the charging capacitor 3. Thus, the current-limiting resistor 8 may limit the charging current of the charging capacitor 3 and protect the charging capacitor 3.

Input terminals of the AC-DC conversion module 4 are respectively coupled to the charging capacitor 3, and output terminals of the AC-DC conversion module 4 are respectively coupled to the detection capacitor 5. The AC-DC conversion module 4 can convert an alternating current generated by the acquisition assembly during a surge of the target line 11 into a direct current and charge the detection capacitor 5. The AC-DC conversion module 4 has a predetermined voltage drop (e.g., 1.4V) internally. During the current variations of the target line 11, the charging capacitor 3 can charge the detection capacitor 5 through the AC-DC conversion module 4 only when the charging capacitor 3 is charged to a voltage that exceeds the predetermined voltage drop of the AC-DC conversion module 4. That is, the AC-DC conversion module 4 can filter out the voltages induced by the acquisition assembly for the 8/20 µs waveform or the 10/350 µs waveform that are lower than the predetermined voltage drop. In addition, since two ends of the detection capacitor 5 are respectively coupled to the output terminals of the AC-DC conversion module 4, that is, the detection capacitor 5 does not have a discharge circuit, the voltage of the detection capacitor 5 can be continuously maintained. Furthermore, when facing surge currents with the same current peak value, the signal detection apparatus 1 can send an early warning for the 10/350 µs waveform before the 8/20 µs waveform.

In some embodiments, if the predetermined threshold of the surge protector 10 is 0.75V, for the 10/350 µs waveform, the surge protector 10 can send the early warning around a peak current of 700A. For the 8/20 µs waveform, the surge protector 10 can send the early warning around 900A.

The pair of voltage detection interfaces 6 are respectively coupled to two ends of the detection capacitor 5, so that the pair of voltage detection interfaces 6 can acquire the voltage of the detection capacitor 5. In some embodiments, the signal detection apparatus 1 further includes an analog-to-digital converter (ADC) coupled to the pair of voltage detection interfaces 6 and adapted to obtain a voltage signal acquired by the pair of voltage detection interfaces 6.

In some embodiments, the signal detection apparatus 1 may further include a micro control unit, where the analog to digital converter is coupled to the micro control unit. The micro controller unit, after detecting the voltage of the detection capacitor 5, can compare it with a predetermined threshold. If the voltage of the detection capacitor 5 exceeds the predetermined threshold, the micro controller unit can send an early warning to control a relevant mechanism of the surge protector 10 to act. Additionally, the micro controller unit can perform statistics (i.e., counting) on surge occurrences in the target line 11 for the user's reference.

In some embodiments, the signal detection apparatus 1 further includes a semiconductor switch 7 coupled to two ends of the detection capacitor 5. The semiconductor switch 7 is adapted to be controlled to be turned on, thereby forming a closed loop at two ends of the detection capacitor 5, and the detection capacitor 5 discharges. The signal detecting device 1 is thus reset, so as to continue to detect surge occurrences of the target line 11.

In some embodiments, the semiconductor switch 7 may be a metal-oxide-semiconductor field-effect transistor (MOSFET) 7, and a source (S) and a drain (D) of the MOSFET 7 are respectively coupled to two ends of the detection capacitor 5. A gate (G) of the MOSFET 7 is coupled to the micro control unit. In this way, the micro control unit can control the signal detection apparatus 1 to be reset through the MOSFET 7.

In some embodiments, a protective diode 9 is connected in parallel to two ends of the detection capacitor 5. In some embodiments, the protective diode 9 may be a Zener diode 9, and the protective diode 9 may be broken down upon the voltage across the detection capacitor 5 being higher than the predetermined threshold. Thus, a closed loop is formed across two ends of the detection capacitor 5, and the detection capacitor 5 is discharged. In this way, the signal detection apparatus 1 is protected.

Various implementations of the present disclosure have been described above, which are illustrative, not exhaustive, and are not limited to the implementations disclosed. Many modifications and variations will be apparent to those of ordinary skill in the art without departing from the scope of the various implementations illustrated. The selection of the terms used herein is intended to best explain the principles of the implementations, practical applications, or improvements to techniques in the marketplace, or to enable others of ordinary skill in the art to understand the various implementations disclosed herein.

## Claims

1. A signal detection apparatus (1) for a surge protector, the signal detection apparatus (1) comprising:
an acquisition assembly for coupling to a target line (11) and adapted to acquire a surge signal in the target line (11), the acquisition assembly comprising at least two acquisition coils (2) connected in series in sequence, the at least two acquisition coils (2) being arranged to be in a radial direction of the target line (11) that is perpendicular to an axis of the target line (11) and at least partially extending along a circumferential direction of the target line (11);
a charging capacitor (3), two ends of which are respectively coupled to the acquisition assembly, and adapted to be charged by the acquisition assembly during current fluctuation of the target line (11);
an AC-DC conversion module (4) connected in parallel to the charging capacitor (3) and adapted to convert an AC voltage output by the charging capacitor (3) into a DC voltage;
a detection capacitor (5) coupled to the AC-DC conversion module (4) and adapted to be charged by the AC-DC conversion module (4); and
two voltage detection interfaces (6) respectively coupled to two ends of the detection capacitor (5) and adapted to detect a voltage across the detection capacitor (5).

2. The signal detection apparatus (1) of claim 1, wherein the at least two acquisition coils (2) comprise two acquisition coils (2) arranged on two opposite sides of the target line (11), and winding directions of the two acquisition coils (2) are opposite.

3. The signal detection apparatus (1) of claim 2, wherein each of the at least two acquisition coils (2) is a Rogowski coil.

4. The signal detection apparatus (1) of any of claims 1 to 3, comprising a semiconductor switch (7) coupled to two ends of the detection capacitor (5).

5. The signal detection apparatus (1) of claim 4, wherein the semiconductor switch (7) comprises a MOSFET (7), a source and a drain of which are respectively coupled to two ends of the detection capacitor (5).

6. The signal detection apparatus (1) of any of claims 1 to 5, comprising a current-limiting resistor (8) arranged between the acquisition assembly and the charging capacitor (3) and coupled in series to the charging capacitor (3).

7. The signal detection apparatus (1) of any of claims 1 to 6, comprising a protective diode (9) connected in parallel to two ends of the detection capacitor (5) and adapted to be broken down upon the voltage across the detection capacitor (5) being greater than a predetermined threshold.

8. The signal detection apparatus (1) of claim 7, wherein the protective diode (9) is a Zener diode (9).

9. The signal detection apparatus (1) of any of claims 1 to 8, comprising an analog-to-digital converter (ADC) coupled to the voltage detection interfaces (6) and adapted to acquire a voltage signal acquired by the voltage detection interfaces (6).

10. A surge protector, comprising the signal detection apparatus (1) of any of claims 1 to 9.
